# EUROPEAN PATENT SPECIFICATION

(11) **EP 2 188 413 B1**
(45) Date of publication and mention of the grant of the patent: **11.07.2018**
(21) Application number: 08793849.4
(22) Date of filing: 20.08.2008
(51) Int. Cl.: C23C 16/02, C23C 16/455

(54) **METHOD FOR ATOMIC LAYER DEPOSITION USING AN ATMOSPHERIC PRESSURE GLOW DISCHARGE PLASMA**
VERFAHREN ZUR ATOMLAGENABSCHEIDUNG UNTER VERWENDUNG EINES ATMOSPHÄRENDRUCK-GLIMMENTLADUNGSPLASMAS
PROCÉDÉ POUR LE DÉPÔT DE COUCHES ATOMIQUES UTILISANT UN PLASMA DE DÉCHARGE LUMINESCENTE À PRESSION ATMOSPHÉRIQUE

(30) Priority: 07.09.2007 EP 07115963
(43) Date of publication of application: 26.05.2010
(73) Proprietor: Fujifilm Manufacturing Europe B.V., 5047 TK Tilburg (NL)
(72) Inventor: DE VRIES, Hindrik Willem, 5045 CM Tilburg (NL)
(74) Representative: Nederlandsch Octrooibureau
(86) International application number: PCT/NL2008/050557
(87) International publication number: WO 2009/031886

(56) References cited:
- US-A1- 2003 114 018
- US-A1- 2005 084 610
- US-A1- 2005 172 897
- US-B1- 6 897 119
- JOO-HYEON LEE ET AL: "Investigation of silicon oxide thin films prepared by atomic layer deposition using SiH2Cl2 and O3 as the precursors" JAPANESE JOURNAL OF APPLIED PHYSICS, PART 2 (LETTERS) JAPAN SOC. APPL. PHYS JAPAN, vol. 43, no. 3A, 1 March 2004 (2004-03-01), pages L328-L330, XP002468827 ISSN: 0021-4922
- LANGEREIS E ET AL: "Plasma-assisted atomic layer deposition of Al2O3 moisture permeation barriers on polymers" APPLIED PHYSICS LETTERS, AIP, AMERICAN INSTITUTE OF PHYSICS, MELVILLE, NY, US, vol. 89, no. 8, 25 August 2006 (2006-08-25), pages 81915-81915, XP012088600 ISSN: 0003-6951

## Description

### Field of the invention

The present invention relates to a method as set forth in claim 1 for atomic layer deposition on the surface of a substrate. In a further aspect, an apparatus for atomic layer deposition on the surface of a substrate is disclosed including an atmospheric plasma system. In an even further aspect the apparatus is used for the deposition of a chemical substance or element.

### Prior art

Atomic layer deposition (ALD) is used in the art to provide layers of a material on the surface of a substrate. Different from chemical vapor deposition (CVD) and physical vapor deposition (PVD), atomic layer deposition (ALD) is based on saturated surface reactions. The intrinsic surface control mechanism of ALD process is based on the saturation of an individual, sequentially-performed surface reaction between the substrate reactive sites and precursor molecules. The saturation mechanism makes the film growth rate directly proportional to the number of reaction cycles instead of the reactant concentration or time of growth as in CVD and PVD.

The article by Joo-Hyeon Lee 'Investigation of silicon oxide thin films by atomic layer deposition using SiH2Cl2 and O3 as the precursors' discloses a method of depositing silicon oxide thin films by ALD using SiH2CL2 and ozone as precursors. The ozone is obtained using a remote corona plasma discharge. The layer is deposited at a high processing temperature of 300 °C.

American patent publication US2005/0084610 discloses a chemical vapor deposition process for atomic layer deposition on the surface of a substrate. The deposition process is made more effective using a radical generator during the deposition process, e.g. a plasma generator, such as an atmospheric pressure glow discharge plasma. In the process disclosed, the precursor molecules are decomposed before reacting with the surface.

American patent US 6,897,119 B1 discloses an apparatus and method for ALD to achieve very thin film depositions. A remote plasma generator is used (reference numeral 39 in Fig. 11), but no specific details are mentioned thereof in the description. The reaction chamber 31 is connected to a vacuum pump 36, which indicates that this process is a very low pressure environment.

American patent publication US2003/114018 discloses a method for fabricating a semiconductor component. A dielectric layer is formed using an ALD process, by first conditioning the surface of the substrate prior to deposition of a monolayer. The first step (conditioning the surface) comprises the application of a free radical generator, and examples such as a pulsed O2, pulsed H2, and pulsed NH3 plasma treatment are mentioned.

ALD is a self-limiting reaction process, i.e. the amount of deposited precursor molecules is determined only by the number of reactive surface sites on the substrate surface and is independent of the precursor exposure after saturation. In theory, the maximum growth rate is exactly one monolayer per cycle, however in most cases because of various reasons the growth rate is limited to 0.2-0.3 of a monolayer. The ALD cycle is composed of four steps. In general it is performed in one single treatment space. It starts as step 1 with providing the surface of a substrate with reactive sites. As a next step a precursor is allowed to react with the reactive sites and the excess material and reaction products are purged out of the treatment space and, ideally, a monolayer of precursor remains attached to the substrate surface via the reactive surface sites (step 2). A reactive agent is introduced into the treatment space and reacts with the attached precursor molecules to form a monolayer of the desired material having reactive sites again (step 3), after which unreacted material and by-product is purged out. Optionally the cycle is repeated to deposit additional monolayers (step 4). With each cycle basically one atomic layer can be deposited which allows a very accurate control of film thickness and film quality.

In the prior art, several methods have been developed to enhance the reaction step in this ALD process, e.g. thermal ALD and plasma assisted ALD. The plasma as used in known ALD methods may be a low pressure RF plasma or an inductively coupled plasma (ICP), and may be used to deposit Al₂O₃, HfO₂, Ta₂O₅ and many other materials.

International patent publication WO01/15220 describes a process for deposition of barrier layers in integrated circuits, in which ALD is used. In the ALD steps, low pressure is used (of about 10 Torr (1330 Pa)) in combination with a thermal reaction step at a high temperature (up to 500°C). Alternatively it is suggested to use a plasma to produce a reactive environment. All disclosed embodiments describe a very low pressure environment, requiring special measures in the apparatus used.

US patent application US2004/0219784 describes methods for forming atomic layers and thin films, using either thermal reaction steps, or plasma assisted reaction steps, in which radicals are formed remotely form the substrate and transported thereto. Again, these processes are performed at relatively high temperature (100-350°C) and low pressure (almost vacuum, typically 0.3 to 30 Torr (40 to 4000 Pa)).

US patent application US2003/0049375 discloses a CVD process to deposit a thin film on a substrate using a plasma assisted CVD process. The formation of a plurality of atomic layers is claimed.

The known ALD methods as described above are mainly performed under low pressure conditions, and usually require vacuum equipment. Furthermore, the ALD methods described using thermal reaction steps (at temperatures well above room temperature, e.g. even 300-900°C), are not suitable for deposition of material on temperature sensitive substrates, such as polymer substrates.

### Summary of the invention

According to the present invention, it has been surprisingly found that plasma enhanced ALD using an atmospheric pressure plasma can also be used, even for substrates which may negatively influence the plasma generation or which are sensitive to environmental factors normally encountered with ALD. Therefore, a method according to the preamble above is provided, comprising conditioning the surface for atomic layer deposition by providing reactive surface sites (step A), providing a precursor material to the surface for allowing reactive surface sites to react with precursor material molecules to give a surface covered by a monolayer of precursor molecules attached via the reactive sites to the surface of the substrate (step B); and subsequently providing a gas mixture generated in an atmospheric pressure glow discharge plasma remote from the substrate and applying said gas mixture subsequently to the surface covered with precursor molecules, said gas mixture comprising a reactive agent capable to convert the attached precursor molecules to active precursor sites. (step C). The steps of providing precursor material and of applying the gas mixture generated in an atmospheric pressure plasma to the surface may be repeated consecutively in order to obtain multiple layers of material on the substrate surface. It is noted that during step C, i.e. the application of the atmospheric pressure plasma, no precursor molecules are present, as the plasma is used to perform a surface dissociation reaction. This dissociation reaction may be supported using a reactive molecule like oxygen, water, ammonia, hydrogen, etc.

Using this method a single atomic layer of reacted precursor, or two or more atomic layers of reacted precursor can be attached to the surface, where each layer might comprise a different reacted precursor.

After providing the precursor material to the surface (step B of this method), precursor molecules react with reactive substrate surface sites.

In a further embodiment a purging step using an inert gas or inert gas mixture may be used hereafter to remove the excess of precursor molecules and/or the molecules formed in this reaction.

When the surface is exposed to the atmospheric plasma (step C of this method) a reactive step takes place in which the precursor molecules attached to the substrate surface via the reactive surface sites are converted to reactive precursor surface sites. In a further embodiment, the more or less volatile molecules formed at this stage may be removed via a purging step using an inert gas or inert gas mixture.

Use of an atmospheric plasma obviates the need to work at very low pressure. All steps of the ALD process can now be executed at around atmospheric pressure. Hence no complex constructions are necessary to obtain a vacuum or near vacuum at the substrate surface during processing.

In an embodiment, the substrate is a flexible substrate, e.g. of polymeric material or a flexible metal substrate. The present treatment method is particularly suited for such a substrate material, with regard to the operating environment (temperature, pressure, electrical field) and allows the use of such material without necessitating further measures.

The substrate may comprise a material which influences an electrical field in its vicinity in a further embodiment, such as a conductive material, a metal, etc. The vicinity of the substrate is herein intended as the direct surrounding of the substrate, e.g. within 1 cm from the substrate, which results in a change of a local electrical field (e.g. change in magnitude, or in electric field line orientation). As the plasma generation is remote from the substrate exposure to the plasma, the plasma generation is not negatively affected by the substrates in this case. When the substrate would pass through the space between electrodes of the plasma generator, the plasma generation would be severely affected.

In a further embodiment, the substrate comprises a material which is sensitive for exposure to oxygen or moisture. The present methods are very well suited for applying a layer on a substrate in order to encapsulate the substrate. This may protect the sensitive surface (or components thereon) which are e.g. sensitive to exposure to oxygen or water vapor (such as OLED and OTFT substrates). Especially when very thin conformal layers are needed (e.g. for flexible substrates), this method is very advantageous.

In a further embodiment, the reactive agent is a reactive gas, the reactive gas comprising one of the group of oxygen, ammonia, an oxygen comprising agent, a nitrogen comprising agent. The precursor material is e.g. tri-methyl-aluminum (TMA), which allows growing Al₂O₃ layers on e.g. a Si substrate. The reactive agent mixture may in a further embodiment comprise an inert gas selected from a noble gas, nitrogen or a mixture of these gases.

Conditioning the surface of the substrate for atomic layer deposition may in an embodiment of the present invention comprise providing the surface with reactive groups, such as OH-groups or NH₂-groups, etc.

The used atmospheric plasma can be any atmospheric plasma known in the art.

In a specific embodiment of this invention the atmospheric pressure glow discharge plasma is a pulsed atmospheric pressure glow discharge plasma. In a further embodiment, the pulsed atmospheric pressure glow discharge plasma is stabilized by stabilization means counteracting local instabilities in the plasma.

Executing an ALD process at atmospheric pressure has an additional advantage in that higher reaction rates are possible, which can lead to a higher productivity. With the present method, parallel thin film layers for example as thin as 10 to 100 molecular layers may be obtained, wherein the films have a comparable or better performance to films produced by prior art methods.

In cases, where the substrate cannot withstand high temperatures, prior art ALD methods cannot be used. Using a plasma at atmospheric pressure, the ALD process may even be executed at room temperature, which allows a much larger area of applications, including the deposition of thin layers on synthetic materials such as plastics. This also allows applying the present method for processing of e.g. polymer foils. The substrates used in the deposition process of this invention are not limited to these foils and may include wafers, ceramics, plastics and the like.

In cases where the substrate negatively influences the plasma in between the electrodes and its electrical field, prior art ALD using a plasma atmospheric pressure cannot be used. Especially at atmospheric pressure the electrical field employed in between the electrodes and needed to obtain a stable plasma, is very strong. Small variations in this field induced by the substrate may destabilize the plasma. Therefore the generation of an atmospheric stable plasma comprising the reactive agent in the gas mixture remote from the substrate (i.e. the substrate itself is not allowed to pass the electric field through the electrodes) and a supply means for providing this gas mixture to the substrate are allowing the deposition of atomic layer(s) even for substrates which destabilize the plasma when brought in the electrical field. The method (the remote plasma assisted ALD method) is particularly beneficial to deposit oxygen and moisture barrier layers for high added value packaging purposes e.g. OLED and OTFT encapsulation.

In one embodiment which is not according to the present invention the substrate is in a fixed position and steps B and C are performed in the same treatment space.

The precursor material is provided in a gas mixture with an inert gas (such as Ar, He, N₂) in a pulsed manner in a further embodiment, and the reactive agent is introduced in a gas mixture with an inert gas or inert gas mixture in a pulsed manner. This method further comprises removing excess material and reaction products using an inert gas or inert gas mixture after each pulsed provision of precursor material and pulsed introduction of the reactive agent.

In an alternative embodiment, the precursor material is provided in a gas mixture with an inert gas or inert gas mixture in a pulsed manner, and the reactive agent is introduced in a gas mixture with an inert gas or inert gas mixture in a continuous manner, and the method further comprises removing excess material and reaction products using an inert gas or inert gas mixture after the pulsed provision of precursor material, and during the application of the atmospheric pressure glow discharge plasma.

In a further alternative embodiment, the precursor material is provided in a continuous manner in a first layer near the surface of the substrate only, and the reactive agent is introduced in a gas mixture with an inert gas or inert gas mixture in a continuous manner in a second layer above the first layer.

In another embodiment the substrate is moving, either continuously or intermittently. In this case step B may be done in a first treatment space and step C is done in another, second treatment space. In a further embodiment, a continuous or pulsed flow of a mixture of precursor material and an inert gas or inert gas mixture is provided in the first treatment space and a continuous or pulsed flow of a mixture of a reactive agent and an inert gas or inert gas mixture is provided in the second treatment space.

According to a further embodiment, the precursor material is provided in a concentration of between 10 and 5000 ppm. This concentration is sufficient to obtain a uniform layer of precursor molecules on the substrate surface in step B of the present method.

In an even further embodiment, the gas mixture of the reactive agent and inert gas comprises between 1 and 50% reactive agent. This is sufficient to have a good reaction result in step C of the present method.

The disclosure is furthermore directed to an apparatus which is capable of executing the method of this invention.

An embodiment relates to an apparatus for atomic layer deposition on a surface of a substrate in a treatment space, the apparatus comprising a gas supply device for providing various gas mixtures to the treatment space, the gas supply device being arranged to provide a gas mixture comprising a precursor material to the treatment space for allowing reactive surface sites of the substrate to react with precursor material molecules to give a surface covered by a monolayer of precursor molecules attached via the reactive sites to the surface of the substrate, and to provide a gas mixture comprising a reactive agent capable to convert the attached precursor molecules to active precursor sites, the apparatus further comprising a plasma generator for generating an atmospheric pressure glow discharge plasma in the gas mixture, the plasma generator being arranged remote from the treatment space. The treatment space may be a controlled enclosure, e.g. a treatment chamber, or a controlled treatment location, e.g. as part of a substrate web.

In one embodiment, the apparatus is specifically designed to perform steps B and C of the present method in one single treatment space. For this, the apparatus further comprising a first treatment space in which the substrate is positioned in operation, the gas supply device being further arranged to perform any one of the relevant method claims.

In another embodiment the apparatus is designed with two different treatment spaces, one for step B and one for step C. In this embodiment, the apparatus further comprises a first treatment space in which the substrate is subjected to the gas mixture comprising a precursor material, a second treatment space in which the substrate is subjected to the gas mixture which is generated in the plasma generator remote from the second treatment space and which comprises the reactive agent, and a transport device for moving the substrate between the first and second treatment spaces. The gas supply device may be arranged to apply the relevant method embodiments described above which utilize two treatment spaces, including flushing steps to remove excess of reactants and or formed reaction products.

In still another embodiment the apparatus is designed in such a way to have a multiple sequence of treatment spaces for step B and step C. E.g., a plurality of first and second treatment spaces are placed sequentially one behind the other in a circular or linear arrangement.

The above apparatus embodiments may be designed in such a way, that the substrate may comprise a continuous moving web or an intermittently moving web.

In a further embodiment, the gas supply device is provided with a valve device, the gas supply device being arranged to control the valve device for providing the various gas mixtures continuously or in a pulsed manner and for removing excess material and reaction products using an inert gas or inert gas mixture. The valve device may comprise one or more valves.

An even further embodiment is especially suited to ensure that the precursor material is kept near to the substrate surface. To this end, the gas supply device comprises an injection channel having a injection valve positioned near the surface of the substrate, in which the gas supply device is arranged to control the valve device and the injection valve for providing the precursor material in a continuous manner in a first layer near the surface of the substrate only using the introduction channel, and for introducing the reactive agent in a gas mixture with an inert gas or inert gas mixture in a continuous manner in a second layer above the first layer.

In a further embodiment, the plasma generator is arranged to generate a pulsed atmospheric pressure glow discharge plasma. The plasma generator may further comprise stabilization means for stabilizing the pulsed atmospheric glow discharge plasma to counteract local instabilities in the plasma.

In an embodiment, the electrodes of the plasma generator are arranged as a couple of flat plates but advantageously also an array of coupled electrodes of flat plates may be used in a further embodiment. In even further embodiments the electrodes can be arranged as a hollow tube electrode with an inner electrode or even array of such hollow type electrodes with inner electrodes. Also an embodiment with combinations of above mentioned electrodes may be envisaged.

Furthermore the disclosure relates to the use of this apparatus, e.g. for depositing a layer of material on a substrate. The substrate may be a synthetic substrate, e.g. on which an electronic circuit is to be provided, such as for the production of organic LEDs or organic TFTs. The substrate may be a flexible substrate, e.g. of a polymeric material. The thickness of the substrate is not critical and may be even up to 2 cm. These types of substrates are specifically suited to be treated using the present invention embodiments, whereas treatment in prior art systems and methods was not practical or even impossible. Alternatively, the plasma deposition apparatus is used to produce flexible photo-voltaic cells on a flexible substrate. Also, the present invention relates to substrates provided with atomic layers deposited using the apparatus and method of this invention.

### Short description of drawings

The present invention will be discussed in more detail below, with reference to the attached drawings, in which
Fig. 1 shows a schematic view of various steps in a atomic layer deposition process for an exemplary embodiment in which an Al₂O₃ layer is deposited on a substrate having SiOH groups as active surface sites;
Fig. 2 shows a time plot of gas flows in an embodiment using a single treatment space;
Fig. 3 shows a time plot of gas flows in a further embodiment using a single treatment space;
Fig. 4 shows a time plot of gas flows in an even further embodiment using a single treatment space;
Fig. 5a and 5b, show schematic views of an arrangement for processing a substrate according to the present invention;
Fig. 6 shows a schematic view of an embodiment with a moving substrate using two treatment spaces;
Fig. 7 shows an embodiment for an apparatus having a sequence of repeating treatment spaces; and
Fig. 8 shows an embodiment for continuous deposition process using two treatment spaces.

### Detailed description

According to the present invention, an improved method is provided for executing an atomic layer deposition (ALD) process with the aid of an atmospheric pressure plasma remote from the substrate i.e. the so-called remote plasma assisted ALD process. ALD processes may be used to deposit defect free coatings of atomic layers of a material such as Al₂O₃, HfO₂, Ta₂O₅ and many other materials. Prior art methods need a low pressure of typically between 50 mTorr and 10 Torr and/or high temperatures for proper operation.

Different from chemical vapor deposition (CVD) and physical vapor deposition (PVD), atomic layer deposition (ALD) is based on saturated surface reactions. The intrinsic surface control mechanism of ALD process is based on the saturation of an individual, sequentially-performed surface reaction between the substrate and precursor molecules. The saturation mechanism makes the film growth rate directly proportional to the number of reaction cycles instead of the reactant concentration or time of growth as in CVD and PVD.

ALD is a self-limiting reaction process, i.e. the amount of precursor molecules attached to the surface is determined only by the number of reactive surface sites and is independent of the precursor exposure after saturation.

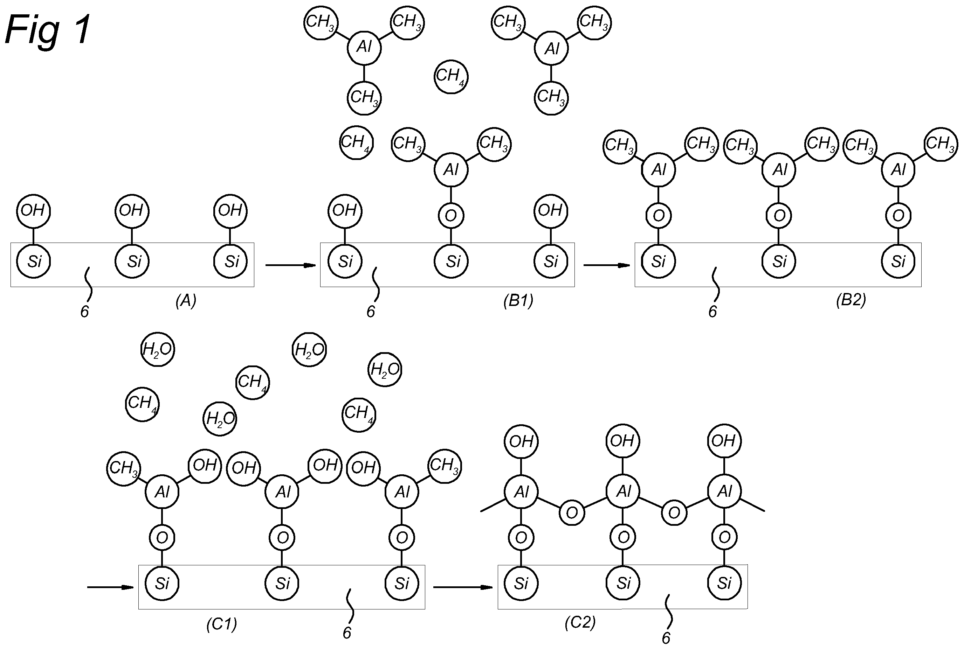

The actual ALD cycle is composed of four steps, as shown in Fig.1 for an exemplary atomic layer deposition of Al₂O₃ on a fixed substrate 6 using tri-methyl-aluminum (TMA) as a precursor and water vapor as an reactive agent.
Step A: Conditioning the surface 6 for atomic layer deposition by providing reactive surface sites, in this case hydroxyl groups on the Si substrate 6 surface, as shown indicated by (A) in Fig. 1.
Step B: Precursor dosing. During this step precursor molecules (TMA) react with the reactive surface sites, as shown indicated by (B1) in Fig. 1. This results in a precursor molecule attached via the reactive sites to the substrate 6 together with more or less volatile other reaction products, such as CH₄. These volatile products, together with possible excess material are purged out of the treatment space and, ideally, a monolayer of precursor remains attached to the substrate 6 surface, as shown indicated by (B2) in Fig. 1.
Step C: A reactive agent (water vapor) is introduced near the substrate 6 surface and reacts with the monolayer of the precursor to form a monolayer of the desired material (Al₂O₃), and more or less volatile reaction products (such as CH₄), as shown indicated by (C1) in Fig. 1. The surface remains populated with reactive sites in the form of hydroxyl groups attached to Al. The volatile reaction products and possibly unreacted agents are purged out as indicated by (C2) in Fig. 1.

Optionally the cycle of steps B and C is repeated to deposit additional monolayers. With each cycle one atomic layer can be deposited which allows a very accurate control of film thickness and film quality. In theory, the maximum growth rate is exactly one monolayer per cycle; however in most cases the growth rate is limited because of various reasons to 0.2-0.5 viz. 0.25-0.3 of a monolayer. One of these reasons may be the steric hindrance by the absorbed precursor molecules.

According to the present invention, a gas mixture which is generated remote from the substrate in an atmospheric pressure plasma which comprises a reactive agent is provided to the substrate in step C for instance by blowing or purging the gas mixture to the substrate to accomplish the reactions. During step C, a gas mixture generated in the plasma is used to enhance removal of the ligands and to replace these by other atoms or molecules. In the exemplary case described above using TMA as precursor, the ligands are formed by the methyl groups and are replaced by oxygen atoms and hydroxyl groups. These hydroxyl groups are suitable for starting the process cycle again from step B.

The ALD process can be carried out as described in the prior art except that the standard low pressure inductively-coupled plasma (ICP) or RF plasma is substituted by an atmospheric pressure plasma step. As a result all the steps involved can now be carried out under atmospheric pressure.

The present invention may be advantageously used when the substrate 6 is of a material which cannot withstand high temperature, such as a polymer foil. The invention is however not limited to polymer foils, as all kind of substrates 6 can be used bearing active sites on the surface. The substrates 6 can be selected from for example ceramics, glasses, wafers, thermo-set and thermo-plast polymers, but also metal (strip) substrates and the like.

In step A of the inventive method, the surface of the substrate to be used is provided with reactive surface sites. This can be done for example through a CVD step. During this CVD step the deposition should be uniform and provide for a uniform distribution of the active sites over the substrate surface. In the example of Fig. 1 these active surface sites are Si-OH groups. These Si-OH groups are suitable for reaction with the precursor molecules. This invention is however not limited to this specific embodiment. What is essential is that the surface of the substrate comprises active sites capable of reacting with a precursor molecule. In one embodiment such surface active site will comprise a hydroxyl group, while in another embodiment the active surface site might comprise a NH2- or NHR-group in which R can be a short chain aliphatic group or an aromatic group. These active groups might be linked to various atoms, like Si, Ti, Al, Fe and so on. Further active sites can be envisaged using P or S.

In step B, the active surface sites of the substrate react with precursor molecules. These precursor molecules may be selected from organometallic compounds and for example halides or substance comprising both halides and organic ligands. The elements of these precursors can be selected from e.g. cobalt, copper, chromium, iron, aluminum, arsenic, barium, beryllium, bismuth, boron, nickel, gallium, germanium, gold, hafnium, lead, magnesium, manganese, mercury, molybdenum, niobium, osmium, phosphorous, platinum, ruthenium, antimony, silicon, silver, sulpher, tantalum, tin, titanium, tungsten, vanadium, zinc, yttrium, zirconium and the like. Precursor molecules comprising more than one element can also be used. Examples for these molecules are:
Bis(N,N'-Diisopropylacetamidinato)cobolt(II); (N,N'-Di-sec-butylacetamidinato)copper(I); (N,N'-Diisopropylacetamidinato)copper(I); Bis(N,N'-Di-tert-butylacetamidinato)iron(II); Bis(N,N'Diisopropylacetamidinato)nickel(II); Aluminum sec-butoxide; Diethylaluminum ethoxide; Trimethylaluminum Tris(diethylamido)aluminum; Tris(ethylmethylamido)aluminum; Diborane (10% in Hydrogen); Trimethylboron; Trimethylgallium; Tris(dimethylamido)aluminum; Digermane (10% in H2); Tetramethylgermanium; Hafnium(IV) chloride; Hafnium(IV) tert-butoxide; Tetrakis(diethylamido)hafnium(IV); Tetrakis(dimethylamido)hafnium(IV); Tetrakis(ethylmethylamido)hafnium(IV); Bis(cyclopentadienyl)magnesium(II); Bis(pentamethylcyclopentadienyl)magnesium(II); Bis(ethylcyclopentadienyl)manganese; Molybdenum hexacarbonyl; Niobium(V) ethoxide; Bis(methylcyclopentadienyl)nickel(II); Bis(ethylcyclopentadienyl)magnesium(II); Cyclopentadienyl(trimethyl)platinum(IV); Bis(ethylcyclopentadienyl) ruthenium(II); Tris(dimethylamido)antimony; 2,4,6,8-Tetramethylcyclotetrasiloxane; Dimethoxydimethylsilane; Disilane; Methylsilane; Octamethylcyclotetrasiloxane; Silane; Tris(isopropoxy)silanol; Tris(tert-butyoxy)silanol; Tris(tert-pentoxy)silanol; Pentakis(dimethylamido)tantalum(V); Tris(diethylamido)(tert-butylimido)tantalum(V); Bis(diethylamino)bis(diisopropylamino)titanium(IV); Tetrakis(diethylamido)titanium(IV); Tetrakis(dimethylamido)titanium(IV); Tetrakis(ethylmethylamido)titanium(IV); Bis(tert-butylimido)bis(dimethylamido) tungsten(VI); Tungsten hexacarbonyl; Tris(N,N-bis(trimethylsilyl)amide)yttrium(III); Diethylzinc; Tetrakis(diethylamido)zirconium(IV); Tetrakis(dimethylamido)zirconium(IV); Tetrakis(ethylmethylamido)zirconium(IV). Preferred as precursor molecules are SiCl₂H₂, SiCl₃H, SiClH₃, SiCl₄, TiCl₄, TICl₃H, TiCl₂H₂ and TiCLH₃.

Also mixtures of these compounds may be used.

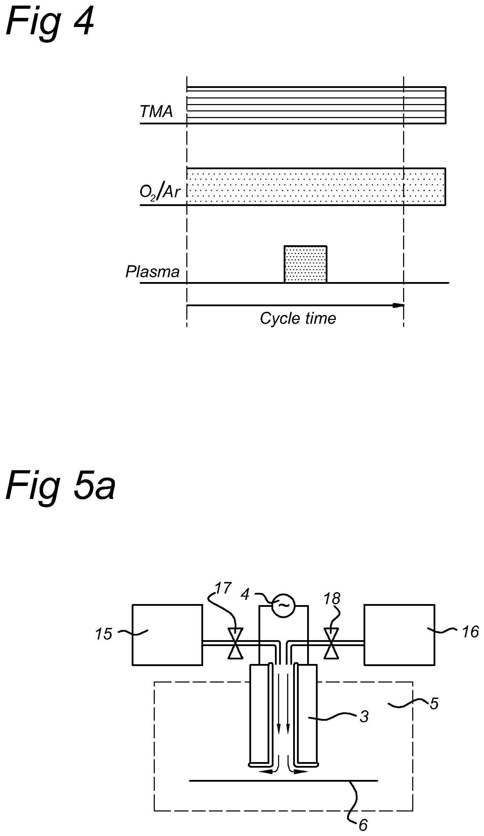

This step B can be done in a treatment space 5 (see e.g. description of Fig. 5a), where the substrate 6 having the reactive site is positioned in a fixed position and not moving. The precursor is inserted in this treatment space 5, after which the reaction occurs with the active surface sites. The precursor is added via an inert carrier gas. This inert carrier gas can be selected from the noble gasses and nitrogen. Also inert gas mixtures can be used as carrier gas. The concentration of the precursor in the carrier gas can be from 10 to 5000 ppm and should be sufficient to make the surface reaction complete. The reaction is in most cases instantaneous. After the reaction between the active surface sites and the precursor is completed, the treatment space 5 is purged or flushed with an inert gas or inert gas mixture, which may be the same gas or gas mixture used as a carrier gas for the precursor, but it may also be a different gas or gas mixture. This step B is most preferably done at room temperature, but it can also be executed at elevated temperature, but should be in any case well below the temperature at which the substrate starts to deteriorate. For plastics like polyethylene the temperature should remain for example preferably below 80°C, but for example for wafers, glasses or ceramics, the temperature, if necessary, can be above 100°C. The substrate 6 provided with the precursor molecules can be stored until the next step or can be subjected to the next step immediately.

In general step C in the ALD process is done at elevated temperatures at sub atmospheric pressure. In this step the precursor molecules attached to the substrate 6 via the active surface sites are converted to a monolayer of the chemical compound which is formed from the precursor molecules after thermal reaction as such, a thermal reaction of the attached precursor with an reactive agent or a thermal reaction enhanced by a low pressure inductive coupled plasma or low pressure RF plasma. So in the prior art step C is performed in general at elevated temperatures viz. over 100°C and at low pressure to have a complete conversion of the precursor molecules to a monolayer of a chemical compound having active sites, suitable for another deposition step B. As stated before, using the method of the prior art it is not possible to use a vast number of thermoplast polymers with relatively low glass temperature Tg as a substrate 6 due to the heating step.

We now have surprisingly found, that step C can be performed at moderate temperature and at atmospheric pressure using an atmospheric plasma and high electrical field, where the plasma is generated in a gas mixture of a reactive agent and an inert gas or inert gas mixture between electrodes remote from the substrate 6. The inert gas can be selected from the noble gasses and nitrogen. The inert gas mixtures can be mixtures of noble gases or mixtures of noble gases and nitrogen. The concentration of the reactive agent in the gas or gas mixture can be from 1% to 50%. The reactive agent basically will react with ligands of the precursor molecule which in step B is attached via the active sites to the substrate 6. This reactive agent can be oxygen or oxygen comprising gases like ozone, water, carbon oxide or carbon dioxide. The reactive agent can also comprise nitrogen or nitrogen comprising compounds such as ammonia, nitrogen oxide, dinitrogen oxide, nitrogen dioxide and the like.

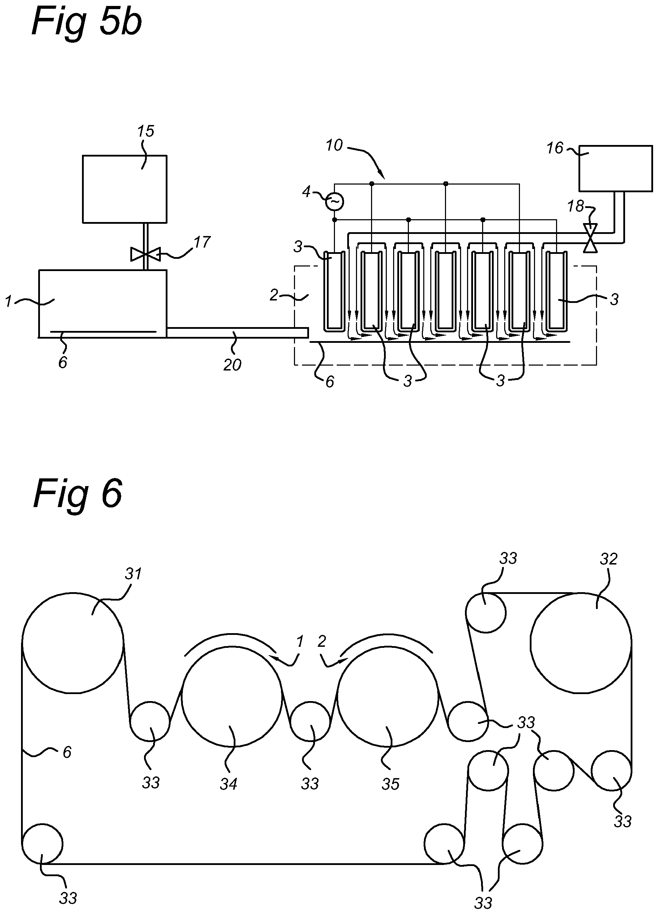

In general the atmospheric pressure plasma is generated between two electrodes. The electrodes of the plasma generator 10 may be arranged as a couple of flat plates 3, connected to a power supply 4, as shown in the embodiment of Fig. 5a or even as an array of coupled electrodes of flat plates connected to a single power supply 4 as shown in the embodiment of Fig. 5b. In another embodiment the electrodes can be arranged as a combination of a hollow tube electrode with an inner electrode or even array of such hollow type electrodes with inner electrodes, in which the gas mixture is subjected to a plasma inside the hollow tube electrode(s).

The atmospheric plasma can be any kind of this plasma known in the art. Very good results are obtained using a pulsed atmospheric pressure glow discharge (APG) plasma. Until recently these plasma's suffered from a bad stability, but using the stabilization means as for example described in US-6774569, EP-A-1383359, EP-A-1547123 and EP-A-1626613, very stable APG plasma's can be obtained. In general these plasma's are stabilized by stabilization means counteracting local instabilities in the plasma.

After step C a substrate is obtained with a monolayer of the chemical compound formed in step C. This monolayer on its turn again has active sites suitable for repeating steps B and C, by which several monolayers can be applied to the substrate one above the other; 10, 20, 50, 100 and even as much as 200 layers can be applied one above the other.

By changing the precursor in a certain cycle, mono-layers of different composition can be applied one above the other, by which very specific properties can be obtained.

There are various embodiments to execute the steps of this inventive ALD method.

In one embodiment the steps are performed in one single treatment space 5 (see e.g. the embodiment described with reference to Fig. 5a below). In this embodiment the substrate 6 is in a fixed position in the treatment space 5. During step B, the deposition of precursor molecules, the substrate 6 can be in a fixed position and during step C, treatment with atmospheric plasma, the substrate 6 can be in a fixed position but might also have a linear speed.

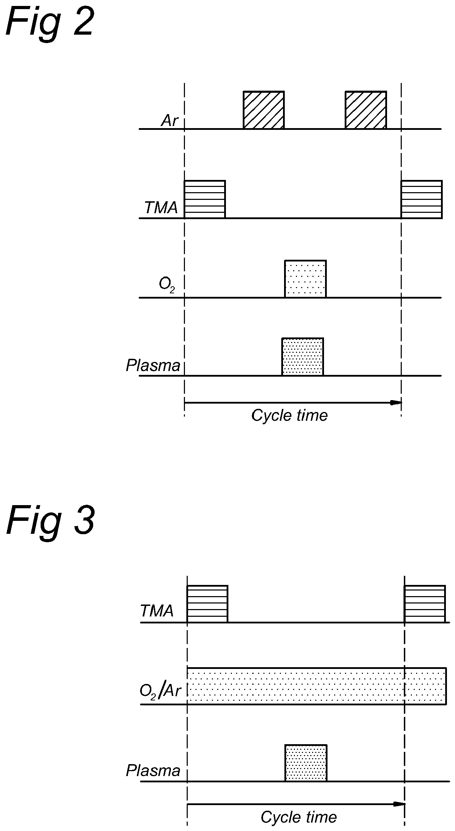

In order to have a satisfactory monolayer deposition method it is important to have a method to control the gas flows. In one embodiment after the gas mixture including the precursor is added to treatment space 5 and reaction is complete, the treatment space is flushed with the inert gas (mixture). After this, an inert gas (mixture) comprising an active gas is inserted between the electrodes 3 of the plasma generator 10 remote from the substrate 6 and after ignition of the plasma is provided to the substrate 6 for instance by blowing or purging the gas mixture to the treatment space 5. The substrate 6 may be moved with a linear speed through the treatment space 5. After this the treatment space 5 is again flushed with an inert gas (mixture) and the steps B and C can be repeated until the wanted number of monolayers is obtained. In this method the precursor material is provided in the gas (mixture) in a pulsed manner, and the reactive agent is introduced in a gas mixture with an inert gas or inert gas mixture also in a pulsed manner, the method further comprising removing excess material and reaction products using an inert gas or inert gas mixture after each pulsed provision of precursor material and pulsed introduction of the reactive agent. This is shown schematically in Fig. 2 in an embodiment, in which TMA is used as precursor, argon as flushing gas and oxygen as reactive agent.

In another embodiment (shown schematically in the timing diagram of Fig. 3) the precursor material (TMA in this example) is provided in a gas mixture with an inert gas in a pulsed manner and the reactive agent (oxygen) is supplied in a continuous manner in the inert gas mixture (with argon), meaning that the gas mixture which is inserted in the treatment space 5 comprises the reactive agent continuously, while the precursor is added discontinuously. This embodiment is possible in case precursor and reactive agent do not or not substantially react with each other in the gas phase. In this embodiment the gas supply method is somewhat simpler than in the first embodiment. In this method excess material and reaction products are purged from the treatment space using an inert gas or inert gas mixture including the reactive agent after each pulsed provision of precursor material and pulsed application of the discharge plasma.

In still another embodiment, as shown in the timing diagram of Fig. 4 the precursor material (TMA) is provided in a continuous manner in an inert gas mixture in a first layer near the surface of the substrate only, and the reactive agent (oxygen) is introduced in a gas mixture with an inert gas (argon) in atmospheric plasma remote from the substrate 6 and supplied in a continuous manner to a second layer above the first layer. In this embodiment laminar flow is a prerequisite. This embodiment is advantageously applied when precursor and reactive agent do not or not substantially react with each other. Still the atmospheric plasma treatment is done in a pulsed manner, by which the method comprises a plasma off time, allowing the precursor to react with active surface sites and a plasma on time where the precursor molecules attached to the surface are converted to the required chemical substance. Although in this embodiment the compositions of the various gas mixtures do not change during the process, control of the flow is important in order to provide a laminar flow.

The embodiments described above are all applicable in case of the availability of one treatment space 5. The method can also be applied when using at least two treatment spaces 1, 2 in which a first treatment space 1 is used for the reaction of the precursor with the active surface sites, while the second treatment space 2 is used for the atmospheric plasma treatment (see embodiment of Fig. 5b, and Fig. 6 described below). In this embodiment the control of the gas compositions and the gas flows is easier and higher efficiencies can be obtained. In this embodiment the substrate 6 is moved continuously through the treatment spaces 1 and 2. As the relevant reactions occurring in the plasma treatment step are quite rapid a moving speed of 1 m/min is quite common, but higher speeds like 10 m/min can be used, while in specific cases a speed as high as 100m/min can be used. The gas flow in this embodiment may be continuous: in treatment space 1 an inert gas (mixture) including the precursor is inserted and in treatment space 2 a gas (mixture) is supplied from the plasma generator 10 including a reactive agent. A further advantage of this embodiment is that the temperature in the first treatment space 1 and the second treatment space 2 need not to be the same, however in case of polymeric substrates the temperature should preferably be below the glass transition temperature which might be below 100°C for one polymeric substrate, but it might be also above 100°C in both treatment spaces 1, 2. In a further embodiment (see description of Fig. 5b) the substrate 6 is not moving continuously, but intermittently, from one treatment space to the other, while during treatment the substrate 6 is not moving.

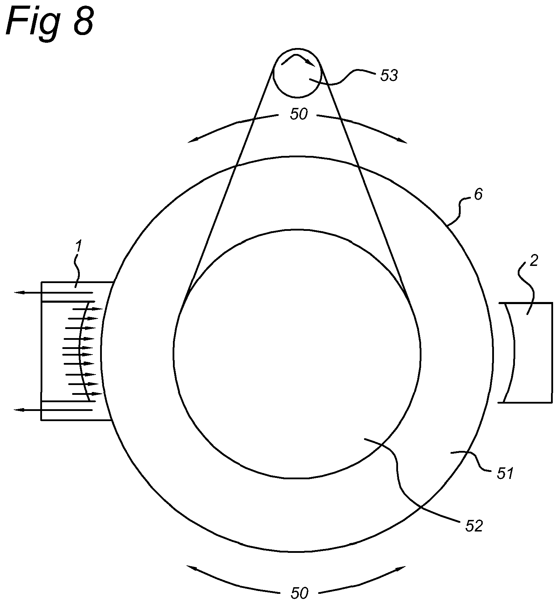

In still other embodiments treatment spaces 1 and 2 and the substrate 6 to be treated form a loop, by which sequences of step B and step C can be repeated in principle endlessly. An implementation of this embodiment is shown schematically in Fig. 6 and Fig. 8, which will be described in more detail below.

In still another embodiment a plurality of first treatment spaces 1 and second treatment spaces 2 are arranged after each other. In this embodiment various monolayers of the same or different composition can be applied over each other using a continuous process. There are no strict requirements for the arrangement of first treatment spaces 1 and second treatment spaces 2 except that in all cases the plasma generator 10 is provided outside the actual treatment space 2 and a supply means is provided for bringing the gas mixture comprising the reactive agent from the plasma generator 10 to treatment space 2 The treatment spaces 1, 2 can be arranged in a linear manner, circular manner or any other arrangement suitable in a continuous process.

In still another embodiment in sub atmospheric pressure plasma may be used at pressures as for example 1 Torr or, 10, 20 or 30 Torr.

In still another embodiment treatment spaces 1 and 2 are decoupled, meaning that first in treatment space 1 a precursor molecule is attached to the active sites of a substrate 6, that this modified substrate 6 is stored under conditions where this substrate 6 is stable, and that at another time the substrate 6 is treated in treatment space 2, where it is subjected to the gas mixture treatment generated in the remote plasma generator 10.

The disclosure is also directed to an apparatus arranged to perform the methods of the present invention.

In one embodiment, which is shown schematically in Fig. 5a, the apparatus comprises a treatment space 5 and a plasma generator 10 for generating an atmospheric pressure plasma between two electrodes 3 remote from the treatment space 5. The electrodes 3 may be provided with a dielectric barrier as indicated by the bold line in Fig. 5a..The apparatus further comprises first gas supply 15 and second gas supply 16. The various components used in this embodiment (precursor, reactive agent, inert gas(mixture)) are injected in the space between the electrodes 3, using the first and second gas supply means 15, 16 and associated valves 17, 18. The first gas supply 15 may be arranged to provide the precursor and an inert gas, and the second gas supply 16 may be arranged to provide the reactive agent and an inert gas.

The first and second gas supply means 15, 16 may be combined in a single gas supply device, which may comprise various gas containers, being provided with mixing means, capable of homogeneously mixing the various gas components accurately providing at the same time various mixtures of different composition or providing various gas mixtures sequentially and capable of maintaining a stable gas flow over a prolonged period of time.

The first and second gas supply means 15, 16 as shown schematically in Fig. 5a could actually consist of a gas shower head with two, three or more outlets where the precursor, reactive, purging gas can be supplied to the process through pulsing. However, thorough mixing is crucial for the uniformity of the deposits.

In this set-up fast switching valves 17, 18 are used in case of the embodiments of Fig. 2 and 3 described above, in which one or more gas streams are applied in a pulsed manner. So for example in the process shown in Fig. 2 the various gas mixtures can be prepared at the same time, meaning, that the sequence of gas additions is controlled by a (set of) valve(s) 17. So when executing step B the valve 17 is switched to the gas mixture comprising the precursor allowing a gas pulse comprising precursor, after this pulse this valve 17 (or another valve 17) is switched to an inert gas composition for purging, after which the valve 18 is switched to the gas composition including the reactive agent to execute step C. As the final step the valve 18 is switched to an inert gas composition for another purge step. The valves 17, 18 which are known as such to the person skilled in the art, and thus not discussed in further detail, are installed as close as possible to the treatment space 5 to prevent mixing and to reduce delay time in the gas flows. To limit gas mixing due to diffusion, rather high gas flows are required (i.e. > 1 m/s). Furthermore, as discussed above, the precursor injection for the embodiment as shown in Fig. 5a should be as near as possible to the substrate 6 surface to confine the precursor flows and limit the diffusion. This may be obtained by having the outflow openings from the electrodes 3 positioned as close as possible to the substrate 6. As an alternative, the outflow of the first gas supply 15 may be positioned close to the substrate 6. In such a manner the ALD mode can be maintained.

As an optional feature, the apparatus may comprise moving means for moving the substrate 6 with a linear speed through the treatment space 5, e.g. in the form of a transport mechanism.

In a further embodiment, which is shown schematically in Fig. 5b, the apparatus comprises a first treatment space 1 which is provided with gas supply means 15 for providing various gas mixtures to the treatment space 1. The gas mixtures can comprise a precursor and an inert gas or inert gas mixture, or an inert gas or inert gas mixture. The gas supply means 15 may comprise various gas containers, and the gas supply means 15 may comprise mixing means, capable of homogeneously mixing the various gas components accurately providing at the same time various mixtures of different composition or providing different gas mixtures sequentially and capable of maintaining a stable gas flow over a prolonged period of time. The sequence of gas additions can be controlled by a (set of) valve(s) 17. So when executing step B of this invention in treatment space 1, the valve 17 is switched to the gas mixture comprising the precursor allowing a gas pulse comprising precursor material, after this pulse this valve 17 or another valve (not shown) is switched to an inert gas composition for purging. Furthermore, the apparatus in this embodiment comprises a second treatment space 2 which is provided with a plasma generator 10 for generating an atmospheric pressure plasma and a second gas supply 16 for providing various gas mixtures to the second treatment space 2, using its associated valve 18. The gas mixture comprises a mixture of a reactive agent and an inert gas or inert gas mixture, or an inert gas or inert gas mixture. The second gas supply again may comprise various gas containers and mixing means capable of homogeneously mixing the various gas components accurately providing at the same time various mixtures of different composition or providing various gas mixtures sequentially and capable of maintaining a stable gas flow over a prolonged period of time. Also in treatment space 2, the sequence of gas additions can be controlled by a (set of) valve(s) 18. After the substrate 6 has entered the second treatment space 2, the valve 18 is switched to the gas composition including the reactive agent to execute step C by igniting the atmospheric discharge plasma and as the final step the valve 18 is switched to an inert gas composition for the purging step. The apparatus further comprises transport means 20 to move the substrate 6 from the first treatment space 1 to the second treatment space 2, e.g. in the form of a transport robot.

The above embodiments as shown in Fig. 5a and 5b have the following common elements. An apparatus for atomic layer deposition on a surface of a substrate 6 in a treatment space 1, 2; 5, the apparatus comprising a gas supply device 15, 16 for providing various gas mixtures to the treatment space 1, 2; 5, the gas supply device 15, 16 being arranged to provide a gas mixture comprising a precursor material to the treatment space 1, 2; 5 for allowing reactive surface sites to react with precursor material molecules to give a surface covered by a monolayer of precursor molecules attached via the reactive sites to the surface of the substrate 6. Subsequently, a gas mixture comprising a reactive agent capable to convert the attached precursor molecules to active precursor sites is provided, and the apparatus further comprises a plasma generator 10 for generating an atmospheric pressure plasma in the gas mixture comprising the reactive agent. Furthermore, the gas supply device 15, 16 is provided with a valve device 17, 18, the gas supply device 15, 16 being arranged to control the valve device 17, 18 for providing the various gas mixtures continuously or in a pulsed manner and for removing excess material and reaction products using an inert gas or inert gas mixture.

In an alternative embodiment, the first gas supply device 15 may comprise an injection channel having a valve 17, which injection channel is positioned near the surface of the substrate 6, and in which the gas supply device 15 is arranged to control the valve 17 for providing the precursor material in a continuous manner in a first layer near the surface of the substrate 6 only using the injection channel. The second gas supply 16 is then arranged for introducing the reactive agent in a gas mixture with an inert gas or inert gas mixture in a continuous manner in a second layer above the first layer.

In a further alternative of this apparatus embodiment, the transport means 20 are arranged to move the substrate 6 continuously with a linear speed or intermittently from the first treatment space 1 to second treatment space 2 (and vice versa for repeating the steps B and C of the present invention).

It will be apparent that the main elements of the embodiments shown in Fig. 5a and 5b may be interchanged, i.e. in the embodiment of Fig. 5a, the multi-electrode arrangement of Fig. 5b may be used, and in the embodiment of Fig. 5b, a single pair of electrodes 3 may be used.

A further apparatus embodiment in which the substrate 6 is provided in the form of an endless web substrate is shown schematically in Fig. 6. The apparatus comprises two main drive cylinders 31, and 32, which drive the substrate 6 via tensioning rollers 33 and treatment rollers 34 and 35. The treatment roller 34 drives the substrate 6 along the first treatment space 1 for performing step B of the present invention, and treatment roller 35 drives the substrate 6 along the second treatment space 2 for performing step C of the present invention. In this embodiment, again the second treatment space 2 is remote from the associated plasma generator 10 in order not to damage the substrate 6.

In a further apparatus embodiment the substrate 6 is wrapped around a cylinder 51 which can be rotated as shown in Fig. 8. Upon rotating the cylinder 51 the substrate 6 passes treatment space 1 for performing step B of the present invention and upon further rotation it passes treatment space 2 for performing step C of the present invention. Again, treatment space 2 is associated with a remotely positioned plasma generator 10, of which examples are shown in Fig. 5a and 5b. In this embodiment a continuous deposition of atomic layers can be achieved. Driving the cylinder 52 may be achieved using a motor 53 driving a drive shaft 52 connected to the cylinder 52 as shown in Fig. 8. Flushing of the substrate 6 may be obtained at the stages where no treatment space 1 or 2 is present around the cylinder 52, as indicated by reference numeral 50 in Fig. 8.

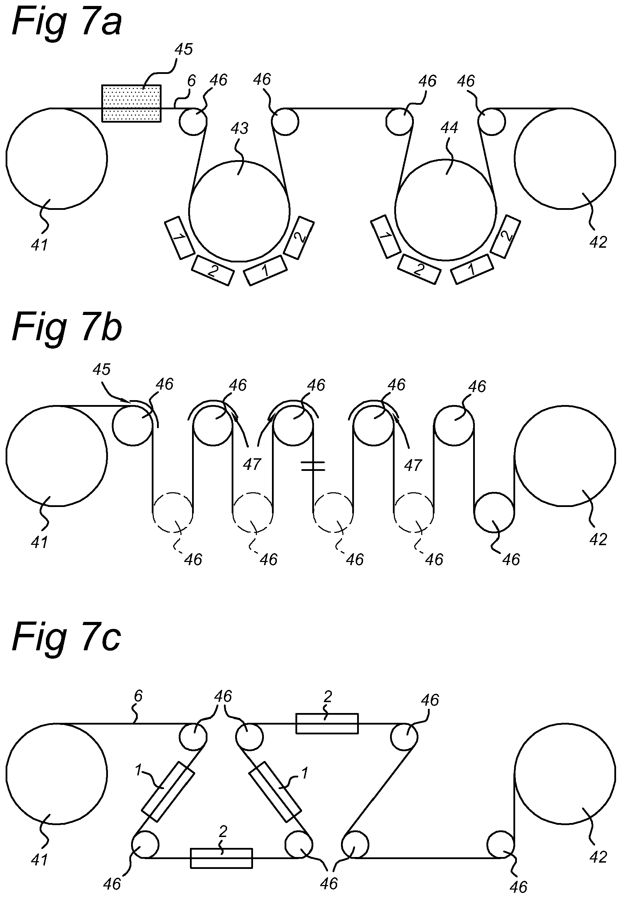

In still a further apparatus embodiment the apparatus is composed of a sequence of first and second treatment spaces 1 and 2 (or alternatively treatment spaces 47) as shown in the various embodiments shown schematically in Figs. 7a, b and c. Again, the second treatment spaces 2 (or treatment space 47) are provided with a plasma generator 10 positioned remote from the substrate 6. In these embodiments, a substrate 6 in the form of a web or the like is transported from an unwinder roller 41 to a winder roller 42. In between the unwinder roller 41 and winder roller 42, a number of tensioning rollers 46 are positioned. This will allow moving the substrate 6 continuously with linear speed or intermittently in the sequence of first and second treatment spaces 1 and 2. Optionally the various treatment spaces 1, 2 are equipped with a lock to keep the precursor and the reactive agent in a confined area. The apparatus of this embodiment is very suitable to deposit various layers on a flexible substrate in which the substrate 6 to be treated is unwound from the unwind roll 41 and the treated substrate 6 is wound on a wind roll 42 again.

In the embodiment alternative as shown in Fig. 7a, the substrate 6 is first treated in a pretreatment space 45, e.g. to execute the first pretreatment step A according to the present invention, as described above. Then, the substrate 6 moves along tensioning roller 46 to a first treatment sequence roller 43. Along the outer perimeter of the first treatment sequence roller 43, a sequence of first and second treatment spaces 1, 2 are positioned, in the shown embodiment two pairs, which allow providing two atomic layers on the substrate 6. The substrate 6 is then moved along further tensioning rollers 46 to a further treatment sequence roller 44 (or even a plurality of further treatment sequence rollers 44), which is also provided with a sequence of first and second treatment spaces 1, 2.

In Fig. 7b, an alternative arrangement is shown schematically. In between the unwind roller 41 and wind roller 42, a large number of tensioning rollers 46 are provided. At the perimeter of the first tensioning roller 46, a pretreatment space 45 is provided, in which step A of the present invention is applied to the substrate 6. At the further tensioning rollers 46, treatment spaces 47 may be provided, at which both steps B and C are applied to the substrate 6. As an alternative, the subsequent treatment spaces 47 may be arranged to apply step B or step C in an alternating manner.

In Fig. 7c, an even further alternative arrangement is shown schematically. In between the unwind roller 41 and wind roller 42, a number of tensioning rollers 46 are provided. In between two tensioning rollers 46, either a first treatment space 1 or a second treatment space 2 is provided to apply step B and step C of the present invention in an alternating manner.

The used plasma for the apparatus embodiments is preferably a continuous wave plasma. A more preferred plasma may be a pulsed atmospheric discharge plasma or a pulsed atmospheric glow discharge plasma. Even more preferred is the use of a pulsed atmospheric glow discharge plasma characterised by an on time and an off time The on-time may vary from very short, e.g. 20 µs, to short, e.g. 500 µs. this effectively results in a pulse train having a series of sine wave periods at the operating frequency, with a total duration of the on-time

The circuitry used in the set-up for the atmospheric glow discharge plasma is preferably provided with stabilization means to counteract instabilities in the plasma. The plasma is generated using a power supply 4 (see Fig 5a, 5b) providing a wide range of frequencies. For example it can provide a low frequency (f=10-450 kHz) electrical signal during the on-time. It can also provide a high frequency electrical signal for example f = 450kHz - 30MHz. Also other frequencies can be provided like from 450kHz-1 MHz or from 1 to 20MHz and the like The plasma electrode can have various lengths and widths and the distance between the electrodes.

The present invention may be applied advantageously in various ALD applications. Especially when using a substrate 6 of a material which influences the electric field in its vicinity, the present invention using a remotely generated plasma has advantages. Such a material may be a conductive material, a metal, etc. The vicinity of the substrate 6 is the direct surrounding of the substrate, e.g. within 1 cm from the substrate, which results in a change of a local electrical field (e.g. change in magnitude, or in electric field line orientation). The invention is not limited to semiconductor applications, but may also extend to other applications, such as packaging, plastic electronics like organic LED's (OLED's) or organic thin film transistor (OTFT) applications. In case of a substrate 6 for manufacturing OLED devices, special precautions should be taken to prevent the OLED substrate 6 from being exposed to oxygen or moisture. Preferred precursors are TiCl₄, SiCl₄ or SiCl₂H₂ and preferred reactive agent and preferred inert gas is nitrogen and ammonia to create an amine terminated surface during the plasma step.

E.g. also high quality photo-voltaic cells may be manufactured on flexible substrates 6. In fact the method and apparatus of the present invention can be used in any application which requires the deposition of various monolayers on a substrate.

Due to the step wise deposition of material at atmospheric pressure, the total deposition rate obtainable is much higher than at low pressure conditions. Very high quality barrier films (water vapor transmission rate (WVTR) of 10⁻⁵-10⁻⁶ g/m²/day) may be obtained using the present invention with a film thickness of only 10-20 nm. Such a low thickness also implies an improved resistance against mechanical stress.

### Example 1:

A sheet prepared with OLED device (substrate 6) was mounted in an experimental set-up as shown in Fig. 8. The complete set-up was placed in a glove box (type Mbraun Labmaster 130) which is purged with pure nitrogen gas. The rotation speed of the drum was set to 15 m/min and the number of rotations was set to 100 cycles.
Step A: A short "direct" plasma step (i.e. the substrate is moved through the electrodes of the plasma) is carried out to form a uniform NH₂-terminated surface layer.
Step B: SiH₂Cl₂ precursor and nitrogen gas are supplied to the surface of the substrate 6. Due to atmospheric pressure SiH₂Cl₂ is reacting very quickly with the amine (NH₂) groups. Typical concentration of SiH₂Cl₂ is 200 mg/hr. Then a purge step is performed using nitrogen.
Step C: After flushing the gap to remove the abundant precursor the ammonia is inserted as reactive agent in a concentration of 1% in inert nitrogen. Subsequently the direct atmospheric (glow) discharge plasma is ignited (either in a single pulse train or in a short sequence of pulse trains) to convert the surface substrate 6 again to an uniform NH₂-terminated surface layer. This is illustrated in the table below for an example with a cycle time of 2 seconds.

| Station# | Gas composition | treatment time | "Direct" Plasma |
|---|---|---|---|
| 1) Nitrogen+SiH2Cl2 | 10 slm +200 mg/hr | 0.5 | Off |
| 2) Nitrogen | 10 slm | 0.7 | Off |
| 3) Nitrogen+ammonia | 10 slm +0.1 slm | 0.1 | On |
| 4) Nitrogen | 10 slm | 0.7 | Off |

| | | | |
|---|---|---|---|
| slm = standard liter per minute | | | |

The treatment times were estimated according to the rotation speed of the drum and the effective length of the process A, B, C and D. Because the line speed is constant the treatment times of the different sub processes can be adjusted by extending or reducing the working length. A dielectric barrier discharge geometry is applied using a frequency of 150 kHz, and a gap width between a DBD electrode and the substrate 6 of 1 mm. The total plasma treatment time used is 100 ms.

After this nitration step the discharge volume is flushed with inert gas (see Fig. 2) and the cycle is repeated. After exposing the final barrier thickness in the plasma assisted ALD process, the OLED device was tested after an ageing test. A strong degradation of the OLED device was observed after 30 hours ageing at 40°C and 90%RH. Many dark spots are present in the device.

### Example 2:

Again a sheet is prepared comprising of OLED devices which was mounted in the experimental set-up as shown in Fig. 8. In this set-up the direct atmospheric pressure plasma unit is replaced by a remote plasma generator using an electrode arrangement of the type shown in Fig 5a.
Step A: A short remote plasma step is carried out to form a uniform -NH₂ terminated surface layer.
Step B: of the SiH₂Cl₂ precursor and nitrogen gas are supplied to the surface. Due to atmospheric pressure SiH₂Cl₂ is reacting very quickly with the amine (NH₂) groups. Typical concentration of SiH2C12 is 200 mg/hr. Then a purge step is performed using nitrogen.
Step C: After flushing the gap to remove the abundant precursor the ammonia is inserted in a concentration of 1% in nitrogen. Subsequently the remote atmospheric discharge plasma is ignited to convert the surface substrate 6 again to an uniform NH₂-terminated surface layer. This is illustrated in the table below for an example with a cycle time of 2 seconds.

| Station# | Gas composition | treatment time | "Remote" Plasma |
|---|---|---|---|
| 1) Nitrogen+SiH₂Cl₂ | 10 slm +200 mg/hr | 0.5 | Off |
| 2) Nitrogen | 10 slm | 0.7 | Off |
| 3) Nitrogen+ammonia | 10 slm +0.1 slm | 0.1 | On |
| 4) Nitrogen | 10 slm | 0.7 | Off |

| | | | |
|---|---|---|---|
| slm = standard liter per minute | | | |

A dielectric barrier discharge geometry is applied using a frequency of 150 kHz, and the distance between DBD electrodes and the substrate 6 of 1 mm.

The substrate was deposited with the same thickness of Si₃N₄ (same number of cycles). The same ageing procedure was carried out exposing the OLED to 40°C and 90%RH. After 100 hours some pinholes could be observed.

### Example 3:

In a further embodiment the remote plasma generator using the electrode arrangement of the type shown in Fig. 5a is replaced by the type of Fig. 5b.
Step A: A short plasma step is carried out to form a uniform NH2 terminated surface layer.
Step B: of the SiH₂Cl₂ precursor and nitrogen gas are supplied to the surface.. Due to atmospheric pressure SiH2C12 is reacting very quickly with the amine (NH₂) groups. Typical concentration of SiH2C12 is 200 mg/hr.
Step C: After flushing the gap to remove the abundant precursor the ammonia is inserted in a concentration of 1% in nitrogen. Subsequently the direct (stabilized) atmospheric discharge plasma is ignited to convert the surface substrate 6 again to an uniform NH₂-terminated surface layer. This is illustrated in the table below for an example with a cycle time of 2 seconds.

| Station# | Gas composition | treatment time | "Remote" Plasma |
|---|---|---|---|
| 1) Nitrogen+SiH2C12 | 10 slm +200 mg/hr | 0.5 | Off |
| 2) Nitrogen | 10 slm | 0.5 | Off |
| 3) Nitrogen+ammonia | 10 slm +0.1 slm | 0.5 | On |
| 4) Nitrogen | 10 slm | 0.5 | Off |

| | | | |
|---|---|---|---|
| slm = standard liter per minute | | | |

The plasma conditions in this embodiment were the use of a dielectric barrier discharge geometry, a frequency of 150 kHz, and the distance between DBD electrodes and the substrate 6 of 1 mm.

The substrate was deposited with the same thickness of Si₃N₄ (same number of cycles). The same ageing procedure was carried out exposing the OLED to 40°C 90%RH. After 200 hours no pinholes could be observed.

Typically 0.5 ML/cycle is deposited using this precursor/gas system. The total thickness of the barrier film deposited is typically 95+/-2 nm in ALD process using exactly 100 cycles.

**X= unacceptable; Δ = acceptable ; ○ = no pin hole formation**

| Example | Plasma set-up | Plasma treatment time [s] | Pinhole formation | Ageing time [hours] |
|---|---|---|---|---|
| 1) comparative | Direct plasma | 0.1 | X | 30 |
| 2) this invention | Single plate remote | 0.1 | Δ | 100 |
| 3) this invention | Multi plate remote | 0.5 | ○ | 200 |

## Claims

1. Method for atomic layer deposition on a surface of a substrate (6), comprising conditioning the surface for atomic layer deposition by providing reactive surface sites; providing a precursor material to the surface for allowing reactive surface sites to react with precursor material molecules to give a surface covered by a monolayer of precursor molecules attached via the reactive sites to the surface of the substrate; and subsequently providing a gas mixture generated in a plasma remote from the substrate and applying said gas mixture subsequently to the surface covered with precursor molecules wherein the gas mixture is generated in an atmospheric pressure glow discharge plasma, said gas mixture comprising a reactive agent capable to convert the attached precursor molecules to active precursor sites, in which the precursor material is provided to the surface in a first treatment space (1) and the surface is exposed in a second treatment space (2), the first treatment space (1) and second treatment space (2) being different, and in which the reactive agent mixture further comprises an inert gas selected from a noble gas, nitrogen or a mixture of these gases.

2. Method according to claim 1, in which the substrate (6) is a flexible substrate.

3. Method according to claim 1 or 2, in which the substrate (6) comprises a material which influences an electrical field in its vicinity.

## Patentansprüche

1. Verfahren zur Atomlagenabscheidung auf einer Oberfläche eines Substrates (6), umfassend Konditionieren der Oberfläche für die Atomlagenabscheidung durch Bereitstellen von reaktiven Oberflächenstellen; Bereitstellen eines Vorstufenmaterials an der Oberfläche, um die reaktiven Oberflächenstellen mit den Vorstufenmaterial-Molekülen reagieren zu lassen, um eine Oberfläche, bedeckt mit einer Monolage aus Vorstufenmolekülen, die über die reaktiven Stellen an die Oberfläche des Substrates gebunden sind, zu ergeben; und anschließend Bereitstellen eines Gasgemisches, das in einem Plasma entfernt von dem Substrat erzeugt wird, und Aufbringen des Gasgemisches danach auf die mit den Vorstufenmolekülen bedeckte Oberfläche, wobei
das Gasgemisch in einem Atmosphärendruck-Glimmentladungsplasma erzeugt wird, wobei das Gasgemisch ein reaktives Mittel umfasst, das imstande ist, die gebundenen Vorstufenmoleküle in aktive Vorstufenstellen zu überführen, wobei das Vorstufenmaterial in einem ersten Behandlungsraum (1) an der Oberfläche bereitgestellt wird und die Oberfläche in einem zweiten Behandlungsraum (2) exponiert wird, wobei der erste Behandlungsraum (1) und der zweite Behandlungsraum (2) unterschiedlich sind, und wobei das Gemisch mit einem reaktiven Mittel weiterhin ein Inertgas, ausgewählt aus einem Edelgas, Stickstoff oder einem Gemisch dieser Gase, umfasst.

2. Verfahren nach Anspruch 1, wobei das Substrat (6) ein flexibles Substrat ist.

3. Verfahren nach Anspruch 1 oder 2, wobei das Substrat (6) ein Material umfasst, das ein elektrisches Feld in seiner Nähe beeinflusst.

## Revendications

1. Méthode de dépôt de couche atomique sur une surface d'un substrat (6), comprenant le conditionnement de la surface pour un dépôt de couche atomique en fournissant des sites de surface réactifs ; la fourniture d'un matériau précurseur sur la surface pour permettre aux sites de surface réactifs de réagir avec des molécules de matériau précurseurs pour donner une surface recouverte d'une monocouche de molécules précurseurs fixées par l'intermédiaire des sites réactifs à la surface du substrat ; et la fourniture ultérieure d'un mélange gazeux généré dans un plasma à distance du substrat et l'application ultérieure dudit mélange gazeux sur la surface recouverte de molécules précurseurs, dans laquelle
le mélange gazeux est généré dans un plasma à décharge luminescente sous pression atmosphérique, ledit mélange gazeux comprenant un agent réactif capable de convertir les molécules précurseurs fixées en sites précurseurs actifs, dans laquelle le matériau précurseur est fourni sur la surface d'un premier espace de traitement (1) et la surface est exposée dans un second espace de traitement (2), le premier espace de traitement (1) et le second espace de traitement (2) étant différents, et dans laquelle le mélange d'agents réactifs comprend en outre un gaz inerte sélectionné parmi un gaz noble, de l'azote ou un mélange de ces gaz.

2. Méthode selon la revendication 1, dans laquelle le substrat (6) est un substrat souple.

3. Méthode selon la revendication 1 ou 2, dans laquelle le substrat (6) comprend un matériau qui influence un champ électrique dans son voisinage.
